# EUROPÄISCHE PATENTSCHRIFT

(11) **EP 4 490 783 B1**
(45) Veröffentlichungstag und Bekanntmachung des Hinweises auf die Patenterteilung: **25.02.2026**
(21) Anmeldenummer: 23715015.6
(22) Anmeldetag: 09.03.2023
(51) Int. Cl.: H10F 10/19, H10F 10/166, H10F 77/70, H10K 30/10, H10K 30/57, H10K 30/87, H10K 85/50

(54) **VERFAHREN ZUR HERSTELLUNG VON PEROWSKIT/SILIZIUM-TANDEMSOLARZELLEN**
METHOD FOR PRODUCING PEROVSKITE/SILICON TANDEM SOLAR CELLS
PROCÉDÉ DE PRODUCTION DE CELLULES SOLAIRES TANDEM PÉROVSKITE/SILICIUM

(30) Priorität: 09.03.2022 DE 102022105533
(43) Veröffentlichungstag der Anmeldung: 15.01.2025
(73) Patentinhaber: Helmholtz-Zentrum Berlin für Materialien und Energie GmbH, 14109 Berlin (DE)
(72) Erfinder: SUTTER, Johannes, 10551 Berlin (DE); TOCKHORN, Philipp, 12051 Berlin (DE); BECKER, Christiane, 10318 Berlin (DE); ALBRECHT, Steve, 14542 Werder Havel (DE)
(86) Internationale Anmeldenummer: PCT/DE2023/100180
(87) Internationale Veröffentlichungsnummer: WO 2023/169631

(56) Entgegenhaltungen:
- WO-A1-2021/030491
- RAZZAQ ARSALAN ET AL: "Infrared Absorption Enhancement Using Periodic Inverse Nanopyramids in Crystalline-Silicon Bottom Cells for Application in Tandem Devices", IEEE JOURNAL OF PHOTOVOLTAICS, IEEE, vol. 10, no. 3, 21 February 2020 (2020-02-21), pages 740 - 748, XP011784940, ISSN: 2156-3381, [retrieved on 20200420], DOI: 10.1109/JPHOTOV.2020.2972324
- FOSTER STEPHEN ET AL: "Light-trapping design for thin-film silicon-perovskite tandem solar cells", JOURNAL OF APPLIED PHYSICS, AMERICAN INSTITUTE OF PHYSICS, 2 HUNTINGTON QUADRANGLE, MELVILLE, NY 11747, vol. 120, no. 10, 103103, 14 September 2016 (2016-09-14), pages 1 - 9, XP012211647, ISSN: 0021-8979, [retrieved on 20160914], DOI: 10.1063/1.4962458
- SHI DAI ET AL: "Perovskite/c-Si tandem solar cell with inverted nanopyramids: realizing high efficiency by controllable light trapping", SCIENTIFIC REPORTS, vol. 5, no. 1, 16504, 13 November 2015 (2015-11-13), pages 1 - 10, XP093046717, DOI: 10.1038/srep16504
- GILIBERTI GEMMA ET AL: "Physical simulation of perovskite/silicon three-terminal tandems based on bipolar transistor structure", PROCEEDINGS OF THE SPIE, SPIE, US, vol. 11996, 1199602, 4 March 2022 (2022-03-04), pages 1 - 7, XP060155502, ISSN: 0277-786X, ISBN: 978-1-5106-5738-0, DOI: 10.1117/12.2609510
- SUTTER J ET AL: "Periodically Nanostructured Perovskite/Silicon Tandem Solar Cells with Power Conversion Efficiency Exceeding 26%", 2021 IEEE 48TH PHOTOVOLTAIC SPECIALISTS CONFERENCE (PVSC), IEEE, 20 June 2021 (2021-06-20), pages 1034 - 1036, XP033964581, DOI: 10.1109/PVSC43889.2021.9518715
- SUTTER JOHANNES CHRISTIAN: "Advanced Light Management Concepts for Silicon and Perovskite Based Solar Cells, Implementing Tailor-Made Textures in Single-and Multijunction Solar Cell Devices", DISSERTATION, 19 September 2022 (2022-09-19), Berlin, Germany, pages 1 - 136, XP093046721, Retrieved from the Internet <URL:https://depositonce.tu-berlin.de/items/ee6f5a33-12bb-4bcb-bb36-21690b790e1f> [retrieved on 20230513]

## Beschreibung

Die Erfindung betrifft ein Verfahren zur Herstellung von Perowskit/Silizium-Tandemsolarzellen, wie solche aus photovoltaischen Anwendungen bekannt sind. Die Perowskit/Silizium-Tandemsolarzellen sind dabei unbeschränkt auch zur Bildung von Solarmodulen zu verwenden.

Die Verbesserung von Solarzellen erfolgt insbesondere unter dem Gesichtspunkt einer verbesserten Effizienz, d.h. einem verbesserten Verhältnis einer zur Absorption zur Verfügung stehenden Menge an Lichtenergie gegenüber der, durch die Solarzelle in Form von elektrischem Strom nutzbar gemachten Energiemenge.

Neben der Verbesserung der Effizienz von Solarzellen ist u.a. ein weiterer wichtiger Aspekt der der Herstellung derselben, insbesondere unter den Gesichtspunkten, die Herstellung möglichst kostengünstig und geeignet für die Herstellung im Industriemaßstab zu ermöglichen.

Perowskit/Silizium-Tandemsolarzellen sind Kandidaten für eine hohe Effizienz. Zur Effizienz einer Solarzelle tragen dabei mehrere physikalische Eigenschaften einer Solarzelle bei. In dem Übersichtsartikel, Aufsatz 1, von S. Akhil et al. (Review on perovskite silicon tandem solar cells: Status and prospects 2T, 3T and 4T for real world conditions, Materials & Design Vol. 211, 2021, 110138_1-36) sind verschiedene Kenntnisse aus dem Stand der Technik zur Effizienz und Effizienzsteigerung von Perwowskit/Silizium-Tandemsolarzellen dargestellt und auch Aspekte der Herstellung derselben, z.B. auch die Aufbringung von Perowskitschichten auf vorherig aufgebrachte, strukturierte Schichten, besprochen.

Unter anderem ist für die Effizienz der Anteil des Lichts, welches in oder an der Solarzelle reflektiert wird und damit nicht zur Absorption zur Verfügung steht, entscheidend. Reflektiertes Licht steht in stark vermindertem Ausmaß und größtenteils gar nicht zur Absorption in der Solarzelle zur Verfügung und trägt damit auch stark vermindert und überwiegend gar nicht zur Effizienz der Solarzelle bei.

Für die Verringerung des Anteils an reflektiertem Licht gibt es mehrere Ansätze. Ein Ansatz ist es, Grenzflächen zwischen Schichten unterschiedlichen Materials in den Schichtstapeln der Solarzellen zu strukturieren, um insbesondere die Reflexion von Licht zu verringern und auch, um sogenannte Lichteinfangstrukturen (engl. light trapping) bereitzustellen. Die Strukturierung kann dabei derart erfolgen, dass mehrere, aufeinanderfolgende Schichten im Stapel jeweils die gleiche Strukturierung einer zuerst (zuvorderst bzw. in einer Schichtfolge der Aufbringung der Schichten nach untenliegend) aufgebrachten Schicht übernehmen, in dem diese an jeder Stelle einer vorgegebenen Struktur, d.h. in deren Tälern und Höhen, mit immer der gleichen (homogenen) Schichtdicke aufgetragen sind. Eine strukturkonforme Schicht wiederholt die Struktur einer unter dieser liegenden strukturierten Schicht in den für diese wesentlichen Merkmalen der Größenordnungen der Höhe bzw. Tiefe der Strukturen und deren geometrische Ausformung und Abmessungen, am in der Richtung der Schichtfolge gleichen Ort der unterliegenden Schicht. In diesem Zusammenhang wird auch von strukturkonformer Auftragung von Schichten bzw. als zur direkt darunter liegenden Schicht strukturkonform aufgebrachten Schichten gesprochen. Die Replikation der Strukturen hängt dabei von den in der Anwendung eines Verfahrens zur Aufbringung von Schichten unvermeidbaren Schwankungen in der Schichtdicke, hervorgerufen durch letztendlich nicht zur Gänze kontrollierbare experimentelle Bedingungen, ab, wodurch die Bedingung der Strukturkonformität im Sinne einer Kopie der wesentlichen Merkmale der Struktur unter Beibehaltung der durch die Strukturierung bedingten Funktionalität (z.B. Verminderung von Reflektionen) aufzufassen ist.

Für Perowskit/Silizium-Tandemsolarzellen ist der Einfluss von strukturierten Schichten auf die Reflexions- und Lichtstreuungseigenschaften der Solarzelle z.B. in dem Aufsatz 2 von K. Jäger et al. (Prospects of light management in perovskite/silicon tandem solar cells, Nanophotonics; Vol. 10(8), 2021, S. 1991-2000) diskutiert und z.B. auch in dem Aufsatz 3 von F. Sahli et al. (Fully textured monolithic perovskite/silicon tandem solar cells with 25.2% power conversion efficiency, Nature Materials, Vol. 17, 2018, S. 820-826) für eine konkrete Ausführung einer Perowskit/Silizium-Tandemsolarzelle dargestellt. Die Größe und Form der Strukturen ist dabei entscheidend für die Reflexions- und Lichtstreuungseigenschaften. Eine spezielle Form der Strukturierung durch sogenannte invertierte Pyramiden ist in dem Aufsatz 4 von D. Shi et al. (Perovskite/c-Si tandem solar cell with inverted nanopyramids: realizing high efficiency by controllable light trapping, Scientific Reports, 2015, 5:16504, S. 1-10) offenbart, die sich als vorteilhaft für das sogenannte "light trapping" gezeigt hat.

In dem Aufsatz 5 von Y. Hou et al. (Efficient tandem solar cells with solution-processed perovskite on textured crystalline silicon, Science, Vol. 367, 2020, S. 1135-1140) ist die Abscheidung von Perowskitschichten aus der Lösung auf eine strukturierte Schicht zur Bildung von Perowskit/Silizium-Tandemsolarzellen näher untersucht.

In dem Aufsatz 6 von B. Chen et al. (Blade-Coated Perovskites on Textured Silicon for 26%-Efficient Monolithic Perovskite/Silicon Tandem Solar Cells, Joule, Vol. 4, 2020, S. 850-864) ist die Aufbringung einer Perowskitschicht mit dem sogenannten "Blade-Coat"-Verfahren, welches eine Beschichtung aus Schlitzdüsen mit einer zur Glattstreichung bzw. Homogenisierung der Schichtdicke separat mitgeführten Vorrichtung (Rakel), hier eine Vorrichtung zur Bereitstellung eines gleichmäßigen N₂-Stroms, auf strukturierte Schichten vorgestellt.

In dem Aufsatz 7 von M. Saliba et al. (Cesium-containing triple cation perovskite solar cells: improved stability, reproducibility and high efficiency, Energy & Environmental Science, Vol. 9, 2016, S. 1989-1997) ist die Aufbringung von Perowskitschichten durch Aufschleudern (spin coating) offenbart.

Neben dem "Blade-Coat"-Verfahren und der Abscheidung aus der Lösung ist für die Aufbringung von Perowskitschichten auch das sogenannte "spin coating" (dt. Aufschleudern, Rotationsbeschichtung) zur Schichtbildung zu erwähnen. Im Sinne der vorliegenden Erfindung ist mit dem "spin coating" ein einstufiger Prozessschritt adressiert, in dem das zur Bildung einer Perowskitschicht benötigte Material nicht getrennt nach verschiedenen Komponenten der Zusammensetzung des Perowskit nacheinander aufgebracht wird, sondern in einem Schritt als Material selbst. Wiewohl mit dem spin coating qualitativ hochwertige Schichten, die zu hocheffizienten Solarzellen beitragen, herstellbar sind, wie dies z.B. in Aufsatz 2 beschrieben ist, sind nach dem Stand der Technik mit dieser Art der Beschichtung keine strukturkonformen Perowskitschichten herstellbar, wie dies z.B. in dem Aufsatz 3 beschrieben ist.

In dem Aufsatz 8 von B. W. Schneider et al. (Pyramidal surface textures for light trapping and antireflection in perovskite-on-silicon tandem solar cells, Optics Express, Vol. 22, 2014, S. A1422-A1430) wird die Verbesserung der Effizienz durch ein verbessertes Lichtmanagement besprochen und theoretisch aufgezeigt, dass eine strukturkonforme Aufbringung von Perowskitschichten auf strukturierte Siliziumschichten erfolgsversprechend ist. Die betrachtete Strukturierung des Siliziums besteht dabei aus invertierten Pyramiden.

Die Eigenschaften einer mit invertierten Pyramiden strukturierten und mit Gold beschichteten Siliziumschicht zur Absorption im Infrarot ist des Weiteren in dem Aufsatz 9 von J. Hu et al. (Efficient infrared sunlight absorbers based on gold-covered, inverted silicon pyramid arrays, Materials Advances, Vol. 3, 2022, S. 2364-2372) aufgezeigt, in welchem auch ein Verfahren zur Herstellung der invertierten Pyramiden mittels Nanoprägelithografie beschreiben ist. In der US 4 528 260 A ist ein fotolithografisches Verfahren zur Herstellung invertierter Pyramiden in Silizium aufgezeigt.

Letztlich ist die EP 3 893 285 A1 zu erwähnen, in der ein Verfahren zur Herstellung von Silizium/Perowskit-Tandemsolarzellen offenbart ist. Die Perowskitschichten sind hierbei insbesondere aus laminierten, d.h. übereinander geschichteten, Perowskiten unterschiedlicher Zusammensetzung gebildet. Die Tandemsolarzelle insgesamt ist insbesondere monolithisch aufgebaut und kann auf einer mit irregulären Pyramiden texturierten Siliziumschicht aufgebaut sein, auf die Schicht für Schicht die übrigen, funktionalen Schichten der Tandemsolarzelle aufgetragen werden. Die Figuren legen dabei eine strukturkonforme Abscheidung der Schichten nahe. Ein weiteres Verfahren zur Herstellung von Silizium/Perowskit-Tandemsolarzellen ist aus WO 2021/030491 A1 bekannt.

Aufgabe der Erfindung ist es, ein Verfahren zur Herstellung von Perowskit/Silizium-Tandemsolarzellen anzugeben, dass eine, unter dem Gesichtspunkt einer verringerten Reflexion optimierte Strukturierung aufweist und gleichzeitig, eine Auftragung von Perowskitschichten erlaubt, die zu hoher Effizienz der hergestellten Solarzellen führt. Die Aufgabe wird durch die Merkmale des Anspruchs 1 gelöst.

Überraschend konnte am HZB eine Vorschrift für ein Verfahren zur Herstellung von Perowskit/Silizium-Tandemsolarzellen gefunden werden, die sowohl eine für eine verringerte Reflexion optimierte Strukturierung umfasst und zugleich ein strukturkonformes Aufbringen einer Perowskitschicht durch Aufschleudern (spin coating) ermöglicht. Die Strukturierung zeichnet sich dabei durch einen abgegrenzten Bereich der Dimensionierung invertierter Pyramiden aus, die durch Nanoprägelithografie oder Fotolithographie und trocken- sowie nasschemischem Ätzen eingebracht werden und durch die das Aufschleudern (spin coating) einer strukturkonformen Perowskitschicht durchführbar wird.

Als Perowskit im erfindungsgemäßen Sinne sind alle Verbindungen aufzufassen, die mit der Summenformel ABX3 zu beschreiben sind und in der Kristallstruktur des Minerals Perowskit kristallisiert sind, aufweisend als Bestandteil A beispielsweise Methylammonium (MA), Cäsium (Cs) und/oder Formamidinium (FA), während der Bestandteil B häufig durch Blei (Pb) gegeben ist. X ist beispielsweise Iod (I), Brom (Br) und/oder Chlor (Cl) oder eine Mischung dieser Elemente. Vorzugsweise wird Cs_{0.05}(FA_{0.79}MA_{0.21})_{0.95}Pb(I_{0.79}Br_{0.21})₃ oder ähnliche Zusammensetzungen verwendet.

Das erfindungsgemäße Verfahren zur Herstellung von Perowskit/Silizium-Tandemsolarzellen sieht vor, zunächst einen Siliziumwafer bereitzustellen, welcher nach (100) orientiert und monokristallin ist. Derartige Siliziumwafer für die Herstellung von Solarzellen sind dem Fachmann geläufig. Der Siliziumwafer bildet den Absorber der rückseitigen Subzelle (Silizium-Teilzelle) in der Tandemsolarzelle.

Weitere Schichten, insbesondere zur Komplettierung der Solarzelle, wie z.B. zur Bildung eines p-n-Übergangs mit dem Siliziumabsorber durch eine entsprechende dotierte zusätzliche Siliziumschicht, sind je nach Bedarf in späteren Schritten im Verfahren vorzusehen.

In einem weiteren Schritt erfolgt dann zunächst die Strukturierung einer ersten Seite des Siliziumwafers, wodurch diese als frontseitige Seite festgelegt ist, durch ein Lithografieverfahren, wie z.B. die Nanoprägelithografie oder Fotolithografie ausgeführt, mit einem anschließenden trocken- und nasschemischem Ätzschritt. Die dieser ersten Seite gegenüberliegende zweite Seite des Siliziumwafers ist damit als rückseitig anzusprechen.

Hierzu wird zunächst auf den Siliziumwafer auf der ersten Seite eine Siliziumdioxidschicht mit einer Schichtdicke im Bereich von 200 nm bis 500 nm aufgebracht. Dies erfolgt in vorteilhafter Weise durch plasmaunterstützte chemische Gasphasenabscheidung (PECVD, von engl. plasma-enhanced chemical vapour deposition). Andere Möglichkeiten des Aufbringens der Siliziumdioxidschicht, wie z.B. physikalisches Verdampfen (engl. physical vapor deposiron, PVD) oder Oxidieren bei hohen Temperaturen, sind dem Fachmann bekannt und im erfindungsgemäßen Verfahren ebenso anwendbar. Auf die Schicht aus Siliziumdioxid wird anschließend eine Schicht aus Fotolack (engl. resist), z.B. durch Schleuderbeschichtung oder andere Verfahren aufgebracht. Der Fotolack besteht in vorteilhafter Weise aus einem organischen Material und wird mit einer Schichtdicke im Bereich von 100 nm bis 500 nm aufgebracht.

In den Fotolack wird in einem weiteren Schritt erfindungsgemäß eine regelmäßige Struktur aus zylindrischen Löchern durch Nanoprägelithographie oder Fotolithographie zur Bildung einer Maske eingebracht, wobei erfindungsgemäß die Löcher einen Durchmesser im Bereich von 1 µm bis 5 µm haben und die Löcher im Bereich von 1.5 µm bis 6 µm zueinander beabstandet sind und im Stempel die entsprechenden, zur Erzeugung der Löcher vorgesehenen Zylinder (Durchmesser im Bereich von 1 µm bis 5 µm und Beabstandung von 1.5 µm bis 6 µm zueinander) eine Höhe im Bereich von 100 nm bis 500 nm aufweisen. Die Strukturierung erfolgt mit dem Stempel, welcher in den Fotolack gepresst wird und worauf anschließend der Fotolack durch Bestrahlung mit UV-Licht gehärtet wird. Die Herstellung eines Stempels und weitere Informationen zum Verfahren der Nanoprägelithographie sind z.B. dem Aufsatz 10 von L. J. Guo (Nanoimprint Lithography: Methods and Material Requirements, Advanced Materials, Vol.: 19(4), 2007, S. 495-513) zu entnehmen.

Durch die Maske aus Fotolack wird im Folgenden in die Schicht aus Siliziumdioxid durch gerichtetes (anisotropes), reaktives Ionenätzen die Struktur der Maske aus Fotolack übertragen. Dabei muss experimentell die Ätzdauer eingestellt werden, so dass die Ätzung nur bis zum Erreichen des Siliziumwafers erfolgt. Zum Ionenätzen kommt z.B. in vorteilhafterweise das reaktive Ionenätzen mit einem Plasma z.B. aus Argon und CHF₃ oder SF₆ zum Einsatz. Es entsteht eine Maske in der Siliziumdioxidschicht, die der Maske, welche in den Fotolack eingebracht wurde entspricht. Diese Maske aus Siliziumdioxid ist gegen eine Ätzung mit Kaliumhydroxid oder anderem Ätzmittel hinreichend stabil. Der Fotolack wird üblicherweise mit einem Sauerstoffplasma oder durch nasschemisches Ätzen entfernt.

In dem anschließenden Schritt wird durch die Maske nasschemisch geätzt, in vorteilhafter Weise z.B. mit einer Kaliumhydroxid oder Natriumhydroxid Lösung oder Tetramethylammoniumhydroxid. Die Ätzung erfolgt bis zur Bildung invertierter Pyramiden, d.h. bis die Seitenflächen der Pyramiden sich in einer Spitze treffen. Die durch diese Bedingung bestimmte Ätzdauer ist im Anwendungsfall experimentell zu bestimmen, in dem Resultate der Ätzung z.B. durch Rasterelektronenmikroskopische Aufnahmen überprüft werden und die Ätzdauer dadurch adjustiert wird. In diesem nasschemischen Ätzschritt wird der gesamte Siliziumwafer der Ätzung ausgesetzt. Dadurch kommt es auch an der rückseitigen Siliziumwaferoberfläche, der zweiten Seite, zu Ätzungen, die die Oberfläche dieser zweiten Seite regellos, durch zufällige Pyramidenbildung texturiert.

Die so an der Oberfläche der Vorderseite des Siliziumwafers geschaffenen invertierten Pyramiden haben folgende Abmessungen: Die Basis der Pyramiden weist Abmessungen der Kanten in einem Bereich von 1.5 µm bis 6 µm auf und die Tiefe liegt in einem Bereich von 1 µm bis 4 µm, bei einer Beabstandung von 1.5 µm bis 6 µm. Eine invertierte Pyramide im Sinne der Erfindung ist die umgekehrte räumliche Gestalt (das Negativ) einer Pyramide als Vertiefung in einer Schicht (hier die Siliziumschicht), wobei die Basis der invertierten Pyramide durch die Öffnung in der Schicht bestimmt ist. Es ist zu beachten, dass die Löcher, die durch den Stempel in den Fotolack und durch gerichtetes Ätzen auch in die Schicht aus Siliziumdioxid übertragen werden, im Durchmesser geringer sind, als die Kantenlängen, der durch die trocken- oder nasschemisch Ätzung gebildeten Pyramiden.

Auf die zweite Seite des Siliziumwafers werden zunächst funktionale Schichten aufgebracht, die für eine letztendliche Komplettierung der Tandemsolarzelle, hier insbesondere auch der Silizium-Subzelle benötigt werden aufgebracht. Dies sind mindestens eine Schicht zur Ausformung eines entsprechenden p-n-Übergangs mit dem Siliziumwafer und eine Kontaktschicht. Auf die mit den invertierten Pyramiden strukturierte, erste Seite des Siliziumwafers werden dann strukturkonform funktionale Schichten, und zwar mindestens eine Passivierungsschicht, eine Rekombinationsschicht und eine Lochleiterschicht aufgebracht. Weitere Schichten sind möglich. Die Verfahren zum Aufbringen der Schichten sind dem Fachmann bekannt und der einschlägigen Literatur zu entnehmen.

Anschließend wird eine Perowskitschicht durch Aufschleudern einer Perowskitlösung strukturkonform aufgebracht, wobei die aufgebrachte Perowskitschicht eine Schichtdicke im Bereich von 300 nm bis 700 nm aufweist. Die Perowskitschicht wird dabei durch Aussalzen der aufgebrachten Perowskitlösung und durch anschließendes Ausheizen fertiggestellt.

Zur letztendlichen Komplettierung der Perowskit/Silizium-Tandemsolarzelle werden auf die Perowskitschicht, strukturkonform mindestens folgende funktionale Schichten, Elektronenleiterschicht, Pufferschicht, transparent leitendes Oxid, Metall-Kontakt und eine antireflektive Schicht aufgebracht. Weitere Schichten sind möglich. Die Verfahren zum Aufbringen der Schichten sind dem Fachmann bekannt und der einschlägigen Literatur zu entnehmen.

Die Erfindung betrifft nach dem oben beschriebenen Verfahren die Herstellung von Perowskit/Silizium-Tandemsolarzellen, mit den folgenden Markmalen. Ein Siliziumwafer als Absorber der Silizium-Subzelle ist mit regelmäßig angeordneten invertierten Pyramiden mit Abmessungen von 1.5 µm bis 6 µm für eine Basis der Pyramiden und 1 µm bis 4 µm für die Tiefe der Pyramiden, bei einer Beabstandung von 1.5 µm bis 6 µm strukturiert und wobei alle auf den Siliziumabsorber als untere Schicht folgenden, darüberliegenden Schichten in der Tandemsolarzelle strukturkonform zu der Struktur in der Siliziumschicht gebildet sind, insbesondere mindestens eine Perowskitschicht als Absorber in der Perowskit-Subzelle.

Eine solche Perowskit/Silizium-Tandemsolarzelle hat den Vorteil, dass diese mit dem erfindungsgemäßen Verfahren herzustellen ist und somit eine zur Verminderung von Reflektionen geeignete Strukturierung aufweist und zugleich die Perowskitschicht in der Tandemsolarzelle durch Aufschleudern aufbringbar ist, was eine verbesserte Effizienz bewirkt. In der nach dem erfindungsgemäßen Verfahren hergestellten Perowskit/Silizium-Tandemsolarzelle liegt die Perowskitschicht an beiden Seiten strukturkonform texturiert vor.

Die Erfindung soll in folgendem Ausführungsbeispiel und anhand von 2 Figuren näher erläutert werden.

### Dabei zeigt

- Fig. 1:: Schematische Darstellung einer nach dem erfindungsgemäßen Verfahren hergestellten Perowskit/Silizium-Tandemsolarzelle.
- Fig. 2:: Schematische Darstellung der Schritte (a)-c)) des erfindungsgemäß verwendeten Verfahrens der Nanoprägelithografie (Stand der Technik) und d) REM-Aufnahme einer derart strukturierten Siliziumdioxidschicht zur Herstellung der erfindungsgemäß invertierten Pyramiden in einem Siliziumwafer.

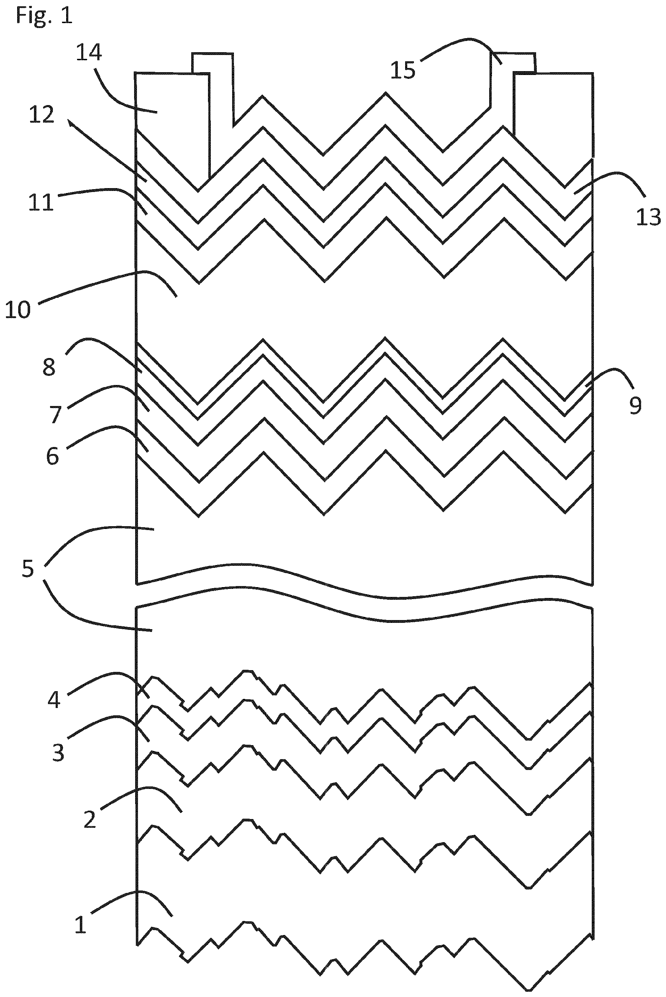

In der Fig. 1 sind die Schichten einer im Ausführungsbeispiel nach dem erfindungsgemäßen Verfahren hergestellten Perowskit/Silizium-Tandemsolarzelle dargestellt. Die Schichten sind dabei wie folgt, von unten nach oben, anzusprechen:
Funktionale Schichten:
   1: Rückseitiger Reflektor (Silber)
   2: Dotiertes SnO (Zinn(II)-oxid)
   3: (p) a-Si:H
   4: (i) a-Si:H
Absorber der Silizium-Subzelle:
   5: Siliziumwafer (unterbrochen dargestellt)
Funktionale Schichten:
   6: (i) a-Si:H
   7: (n) nc-Si:H
   8: dotiertes SnO (Zinn(II)-oxid)
   9: Lochleiterschicht aus Me-4PACz
Absorber der Perowskit-Subzelle:
   10: Perowskit (Cs_{0.05}(FA_{0.79}MA_{0.21})_{0.95}Pb(I_{0.79}Br_{0.21})₃)
Funktionale Schichten:
   11: C₆₀
   12: SnO₂ (Zinn(IV)-oxid)
   13: IZO (Indium-Zink-Oxid)
   14: Silberring (siehe auch unten)
   15: LiF (Lithiumfluorid)

Die Schichtdicken sind nicht maßstabsgetreu dargestellt und dienen nur der Orientierung. Die Nummerierung der Schichten dient nur dem Referenzieren und entspricht der Schichtfolge in der fertiggestellten Tandemsolarzelle, bezieht sich jedoch nicht auf die Abfolge der Schichtaufbringung. Der Siliziumwafer 5 als Absorber ist an einer, in der Figur oben liegenden, ersten Seite gemäß dem erfindungsgemäßen Verfahren mit invertierten Pyramiden strukturiert. Der Siliziumwafer 5 ist für die Schichten 6 - 15 als die untere Schicht, insbesondere auch in Hinblick auf die Abscheidungsfolge der Schichten, anzusprechen. Der Siliziumwafer 5 ist aber ebenfalls für die Folge der Schichtaufbringung -jedoch nicht für die Schichtfolge in der letztendlichen Tandemsolarzelle- für die rückseitigen Schichten 1-4 als die untere Schicht anzusehen. Der Siliziumwafer 5 ist durch den nasschemischen Ätzschritt des erfindungsgemäßen Verfahrens auf beiden Seiten strukturiert. An dem in der Figur oben liegenden, ersten Seite ist er mit dem erfindungsgemäßen Verfahren strukturiert und an der unteren zweiten Seite durch den nasschemischen Ätzschritt mit einer zufälligen Pyramidenstruktur versehen. Sowohl die unteren Schichten (1-4) als auch die oberen Schichten (6-15) sind auf die jeweiligen Oberflächen des Siliziumwafers 5 strukturkonform aufgebracht.

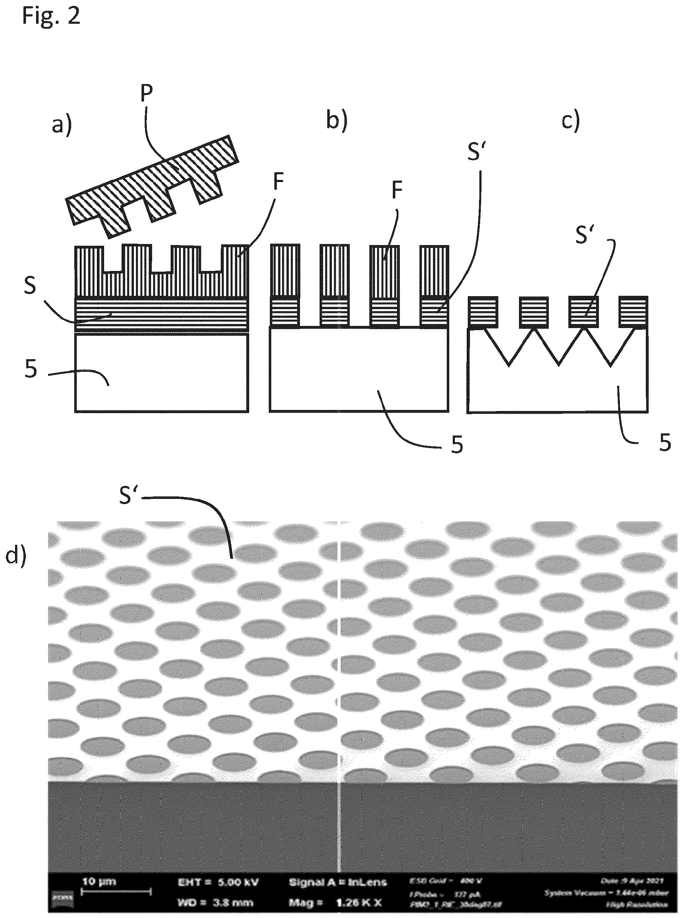

In dem Ausführungsbeispiel für das erfindungsgemäße Verfahren zur Herstellung von Perowskit/Silizium-Tandemsolarzellen wird zunächst ein monokristalliner Siliziumwafer mit (100)-Orientierung (die Netzebenen {100} von Silizium fallen in der Orientierung mit der Oberfläche des Wafers zusammen) bereitgestellt. Der Siliziumwafer 5 wird an einer ersten Seite, mit einer Siliziumdioxidschicht S (in Fig. 1 nicht dargestellt, da im Verfahren wieder entfernt) durch PECVD mit einer Schichtdicke von 260 nm versehen. Auf diese wird ein käuflich zu erwerbender, organischer Fotolack mr-NIL210 der Firma micro resist technology GmbH F mit einer Schichtdicke von 500 nm aufgetragen (in Fig. 1 nicht dargestellt, da im Verfahren wieder entfernt). Mittels Nanoprägelithographie wird eine Lochstruktur in den Fotolack F eingebracht (Fig. 2a)). Dies geschieht mittels eines Stempels P aus Polydimethylsiloxan (PDMS), welcher durch Übertragung aus einer Masterstruktur gebildet ist. Der Stempel P wird in den durch UV-Licht aushärtbaren Fotolack F gedrückt, wonach der Fotolack F mit UV-Licht ausgehärtet wird. Nach dem Abziehen des PDMS-Stempels S wird die in dem Fotolack F reproduzierte Struktur mittels reaktivem Ionen-Ätzens mit einem Plasma aus Argon und CHF₃ in die zuvor auf den Siliziumwafer 5 aufgebrachte Siliziumoxidschicht S gerichtet (anisotrop) geätzt und somit übertragen (Fig. 2b)). Der Fotolack wird mit einem Sauerstoffplasma entfernt. Die so entstandene Siliziumoxidmaske S' ist gegenüber einer Ätzung mit Kaliumhydroxid hinreichend stabil und weist eine durch den Stempel P eingebrachte periodische Lochstruktur mit Löchern mit einem Durchmesser von 2,5 µm und einer Beabstandung von 4 µm auf (Fig. 2d)). Die Löcher in der strukturierten Siliziumdioxidschicht S' reichen bis auf den Siliziumwafer und haben somit eine der Schichtdicke des Siliziumdioxids entsprechende Tiefe. Durch eine Kaliumhydroxidätze werden an den durch die Löcher in der Siliziumdioxidschicht S' definierten Stellen invertierte Pyramiden in dem Siliziumwafer 5 erzeugt (Fig. 2c)), deren Periodizität durch die Maske der Siliziumdioxidschicht S' bestimmt ist. Die Pyramidenbildung erfolgt aufgrund der stark selektiven Ätzpräferenz der (100)-Ebenen des monokristallinen Siliziums 1 bei der nasschemischen Ätzung, im Ausführungsbeislpiel mit Kaliumhydroxid ausgeführt. Es entstehen immer die gleichen Winkel von 54.74° der Pyramidenflanken, wodurch die Tiefe der Pyramidenstrukturen durch den Abstand zur nächsten Pyramide festgelegt ist. Die Pyramiden im Ausführungsbeispiel haben die folgenden Abmessungen von 4 µm der Kanten der Basis der Pyramiden und einer Tiefe von 2.8 µm der Pyramiden bei einer Beabstandung von 4 µm (die Pyramiden kontaktieren sich).

Die Ätzmaske aus Siliziumdioxid wird nach der nasschemischen Ätze mit Kaliumhydroxid durch eine gepufferte Oxidätze (BOE) entfernt. Nach einer Reingung durch eine standardgemäße RCA-Reinigung, wie diese auch in der Mikroelektronik Verwendung findet, wird der beidseitig texturierten Silziumwafer zu einer Perowskit/Silizium-Tandemsolarzelle weiterprozessiert.

Rückseitig werden zur Komplettierung der Tandemsolarzelle und insbesondere auch der Silizium-Subzelle nun zunächst die Schichten, (i) a-Si:H 4, (p) a-Si:H 3, dotiertes Zinn(II)-oxid SnO 2 und ein rückseitiger Reflektor aus Silber 1, mit standardgemäßen Verfahren auf die zweite Seite des Siliziumwafers aufgetragen.

Die erste, frontseitige mit den invertierten Pyramiden strukturierte Seite des Siliziumwafer 5 wird im Ausführungsbeispiel zunächst durch hydrogenisiertes intrinsisches, amorphes Silizium (mittels PECVD) passiviert ((i) a-Si:H, 6) und dann folgende funktionale Schichten strukturkonform hierauf abgeschieden: (n) nc-SiOx:H (hydrogenisiertes n-dotiertes nanocrystalline Siliziumoxid, aufgetragen mittels PECVD) 7, eine Rekombinationsschicht aus transparentem, leitendem Oxid (hier dotiertes Zinnoxid durch Sputtern) 8 und anschließend als selektiver Lochkontakt eine Schicht aus Me-4PACz ([4-(3,6-dimethyl-9H-carbazol-9-yl)butyl]phosphonic acid) 9 mittels Schleuderbeschichtung.

Anschließend wird eine Perowskitschicht 10 bei 3500 rpm für 40 s aufgeschleudert. 5 s vor Ende des Programms, werden 500 µL Essigsäureethylester als Anti-Lösungsmittel zum Aussalzen auf das sich drehende Substrat gegossen. Als Perowskitschicht wird ein "Triple Cation"-Perowskit Cs_{0.05}(FA_{0.79}MA_{0.21})_{0.95}Pb(I_{0.79}Br_{0.21})₃ verwendet. Die aufgeschleuderte Schicht wird anschließend bei 100°C für 30 min getrocknet. Die so entstandene strukturkonforme Perowskitschicht bedeckt die unterliegende Textur komplett (ununterbrochen).

Die Perowskit/Silizium-Tandemsolarzelle wird durch das strukturkonforme Auftragen der funktionalen Schichten Elektronenleiterschicht aus C₆₀ ([60]Fulleren) 11, einer Pufferschicht aus Zinn(IV)-oxid SnO₂ 12, transparent leitende Oxidschicht aus Indiumzinkoxid 13, einem Kontakt Ring bestehend aus Silber14 und eine antireflektive Lithiumflouridschicht LiF 15 in standardmäßigen Verfahren frontseitig komplettiert.

## Patentansprüche

1. Verfahren zur Herstellung von Perowskit/Silizium-Tandemsolarzellen mindestens umfassend die Schritte:
- Bereitstellen eines nach (100) orientierten, monokristallinen Siliziumwafers (5),
- Aufbringen einer Siliziumdioxidschicht (S) auf eine erste Seite des Siliziumwafers (5),
- Aufbringen einer Schicht aus Fotolack (F) auf die Siliziumdioxidschicht (S);
- Einbringen einer regelmäßigen Struktur in den Fotolack (F) durch Nanoprägelithographie mit einem Stempel (P) zur Bildung einer Maske,
- Gerichtetes, reaktives Ionenätzen der Schicht aus Siliziumdioxid (S) durch die Maske aus der Schicht aus Fotolack (F), zur Übertragung der Struktur der Maske in die Siliziumdioxidschicht (S);
- Anschließend nasschemisches Ätzen des Siliziumwafers;
- Aufbringen rückseitiger funktionaler Schichten auf eine zweite Seite des Siliziumwafers (5) und Aufbringen mindestens folgender funktionaler Schichten Passivierungsschicht, Rekombinationsschicht, und Lochleiterschicht (9) auf die erste Seite des Siliziumwafers;
- Anschließend strukturkonformes Aufbringen einer Perowskitschicht (10) durch Aufschleudern einer Perowskitlösung auf die Lochleiterschicht (9)
- Aussalzen der Perowskitlösung und anschließendes Ausheizen, wobei die aufgebrachte Perowskitschicht (10) eine Schichtdicke im Bereich von 300 nm bis 700 nm aufweist;
- Aufbringen frontseitiger funktionaler Schichten zur Komplettierung der Perowskit/Silizium-Tandemsolarzelle,
wobei
die regelmäßige Struktur aus zylindrischen Löchern gebildet ist, wobei die Löcher einen Durchmesser im Bereich von 1 µm bis 5 µm haben und die Löcher im Bereich von 1.5 µm bis 6 µm zueinander beabstandet sind.

## Claims

1. Method for manufacturing perovskite/silicon tandem solar cells, comprising at least the steps of:
- providing a (100)-oriented, monocrystalline silicon wafer (5),
- applying a silicon dioxide layer (S) to a first side of the silicon wafer (5),
- applying a layer of photoresist (F) to the silicon dioxide layer (S);
- introducing a regular structure into the photoresist (F) by nanoimprint lithography with a stamp (P) to form a mask,
- Directed reactive ion etching of the silicon dioxide layer (S) through the mask made of the photoresist layer (F) to transfer the structure of the mask into the silicon dioxide layer (S);
- Subsequent wet chemical etching of the silicon wafer;
- Applying rear functional layers to a second side of the silicon wafer (5) and applying at least the following functional layers: passivation layer, recombination layer, and hole conductor layer (9) to the first side of the silicon wafer;
- Subsequently, structure-compliant application of a perovskite layer (10) by spinning a perovskite solution onto the hole conductor layer (9)
- Desalting the perovskite solution and subsequent baking, wherein the applied perovskite layer (10) has a layer thickness in the range of 300 nm to 700 nm;
- Applying front-side functional layers to complete the perovskite/silicon tandem solar cell,
wherein
the regular structure is formed from cylindrical holes, wherein the holes have a diameter in the range from 1 µm to 5 µm and the holes are spaced apart from each other in the range from 1.5 µm to 6 µm.

## Revendications

1. Procédé de fabrication de cellules solaires tandem pérovskite/silicium comprenant au moins les étapes suivantes :
- fournir une plaquette de silicium monocristallin (5) orientée selon (100),
- application d'une couche de dioxyde de silicium (S) sur une première face de la plaquette de silicium (5),
- application d'une couche de résine photosensible (F) sur la couche de dioxyde de silicium (S) ;
- introduction d'une structure régulière dans la résine photosensible (F) par lithographie par nano-estampage avec un tampon (P) pour former un masque,
- gravure ionique réactive dirigée de la couche de dioxyde de silicium (S) à travers le masque formé par la couche de résine photosensible (F), afin de transférer la structure du masque dans la couche de dioxyde de silicium (S) ;
- Gravure chimique humide de la plaquette de silicium ;
- Application de couches fonctionnelles arrière sur une deuxième face de la plaquette de silicium (5) et application d'au moins les couches fonctionnelles suivantes: couche de passivation, couche de recombinaison et couche conductrice de trous (9) sur la première face de la plaquette de silicium ;
- Puis application d'une couche de pérovskite (10) conforme à la structure par centrifugation d'une solution de pérovskite sur la couche conductrice de trous (9)
- désalinisation de la solution de pérovskite, puis recuit, la couche de pérovskite (10) appliquée présentant une épaisseur comprise entre 300 nm et 700 nm ;
- Application de couches fonctionnelles sur la face avant pour compléter la cellule solaire tandem pérovskite/silicium,
dans laquelle
la structure régulière est formée de trous cylindriques, les trous ayant un diamètre compris entre 1 µm et 5 µm et étant espacés les uns des autres d'une distance comprise entre 1,5 µm et 6 µm.
